# EUROPEAN PATENT APPLICATION

(11) **EP 3 933 888 A1**
(43) Date of publication of application: **05.01.2022**
(21) Application number: 20766136.4
(22) Date of filing: 23.01.2020
(51) Int. Cl.: H01L 21/205, C23C 16/455

(54) **VAPOR PHASE GROWTH APPARATUS**

(30) Priority: 01.03.2019 JP 2019037984
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); YAJIMA, Masayoshi, Yokohama-shi, Kanagawa 235-8522 (JP); SUZUKI, Kunihiko, Yokohama-shi, Kanagawa 235-8522 (JP); ISHIGURO, Akio, Yokohama-shi, Kanagawa 235-8522 (JP)
(74) Representative: Hoffmann Eitle
(86) International application number: PCT/JP2020/002358
(87) International publication number: WO 2020/179272

(57) **Abstract**

A vapor phase growth apparatus of an embodiment includes: a reactor; a first gas chamber provided above the reactor, a first process gas being introduced into the first gas chamber; a plurality of first gas conduits for supplying the first process gas from the first gas chamber to the reactor, each of the first gas conduits having a predetermined length; and a first adjustment conduit inserted to an upper side of one of the plurality of first gas conduits. The first adjustment conduit has an annular protrusion provided on an outer periphery of an upper end portion and is removable from the first gas conduit.

## Description

### TECHNICAL FIELD

The present invention relates to a vapor phase growth apparatus that forms a film by supplying a gas to a substrate.

### BACKGROUND ART

As a method of forming a high-quality semiconductor film, there is an epitaxial growth technique for forming a single crystal film on the surface of a substrate by vapor phase growth. In a vapor phase growth apparatus using an epitaxial growth technique, a substrate is placed on a holder in a reactor held at normal pressure or reduced pressure.

Then, while heating the substrate, a process gas containing the raw material of a film is supplied to the reactor through a buffer chamber at the upper part of the reactor. A thermal reaction of the process gas occurs on the surface of the substrate, and an epitaxial single crystal film is formed on the surface of the substrate.

For example, it may not be possible to obtain the reproducibility of the characteristics of a film formed under the same process conditions between different vapor phase growth apparatuses having the same specifications. The reason is considered to be, for example, a dimensional variation within the processing tolerance of the parts forming each vapor phase growth apparatus. For example, as one of the reasons, it is conceivable that the reproducibility of the pressure distribution in the buffer chamber cannot be obtained due to the dimensional variation of the flow path for supplying the process gas to the buffer chamber, and accordingly, the reproducibility of the film characteristics cannot be obtained.

### CITATION LIST

### PATENT DOCUMENT

Patent Document 1: JP H1-257321 A

### SUMMARY OF THE INVENTION

### PROBLEM TO BE SOLVED BY THE INVENTION

An object to be solved by the invention is to provide a vapor phase growth apparatus capable of improving the reproducibility of film characteristics.

### MEANS FOR SOLVING PROBLEM

A vapor phase growth apparatus according to an aspect of the invention includes: a reactor; a first gas chamber provided above the reactor, a first process gas being introduced into the first gas chamber; a plurality of first gas conduits supplying the first process gas from the first gas chamber to the reactor, each of the first gas conduits having a predetermined length; and a first adjustment conduit inserted to an upper side of one of the plurality of first gas conduits. The first adjustment conduit has an annular protrusion provided on an outer periphery of an upper end portion and the first adjustment conduit is removable from the first gas conduit.

### EFFECT OF THE INVENTION

According to the invention, it is possible to realize a vapor phase growth apparatus capable of improving the reproducibility of film characteristics.

### BRIEF DESCRIPTION OF DRAWINGS

Fig. 1 is a schematic cross-sectional view of a vapor phase growth apparatus of a first embodiment;
Fig. 2 is a schematic cross-sectional view of a first gas conduit and a first adjustment conduit of the first embodiment;
Fig. 3 is a schematic diagram of the first adjustment conduit of the first embodiment;
Fig. 4 is a schematic cross-sectional view of a second gas conduit and a second adjustment conduit of the first embodiment;
Fig. 5 is a schematic cross-sectional view of a first gas conduit and a first adjustment conduit of a second embodiment; and
Fig. 6 is a schematic cross-sectional view of a vapor phase growth apparatus of a third embodiment.

### EMBODIMENT(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. In addition, "upper" means a position opposite to the direction of gravity with respect to the reference, and "upward" means a direction opposite to the direction of gravity with respect to the reference. In addition, "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

Conductance indicates the ease of flow of a fluid flowing through a flow path. For example, the conductance of a cylindrical conduit having an inner diameter of D and a length of L is proportional to D⁴/L. Hereinafter, D⁴/L will be referred to as a conductance coefficient. In addition, in this specification, it is assumed that there is no change in pressure at the inlet and the outlet of the conduit due to the shape change of the conduit. In addition, in the viscous flow region, the conductance is also proportional to the average pressure of the conduit. In this specification, however, this will be omitted in the calculation so as not to be complicated. In this manner, the conductance of the conduit can be treated as being proportional only to the conductance coefficient.

### (First Embodiment)

A vapor phase growth apparatus of a first embodiment includes: a reactor; a first gas chamber provided above the reactor, a first process gas being introduced into the first gas chamber; a plurality of first gas conduits for supplying the first process gas from the first gas chamber to the reactor, each of the first gas conduits having a predetermined length; and a first adjustment conduit inserted to an upper side of one of the plurality of first gas conduits. The first adjustment conduit has an annular protrusion provided on an outer periphery of an upper end portion and is removable from the first gas conduit.

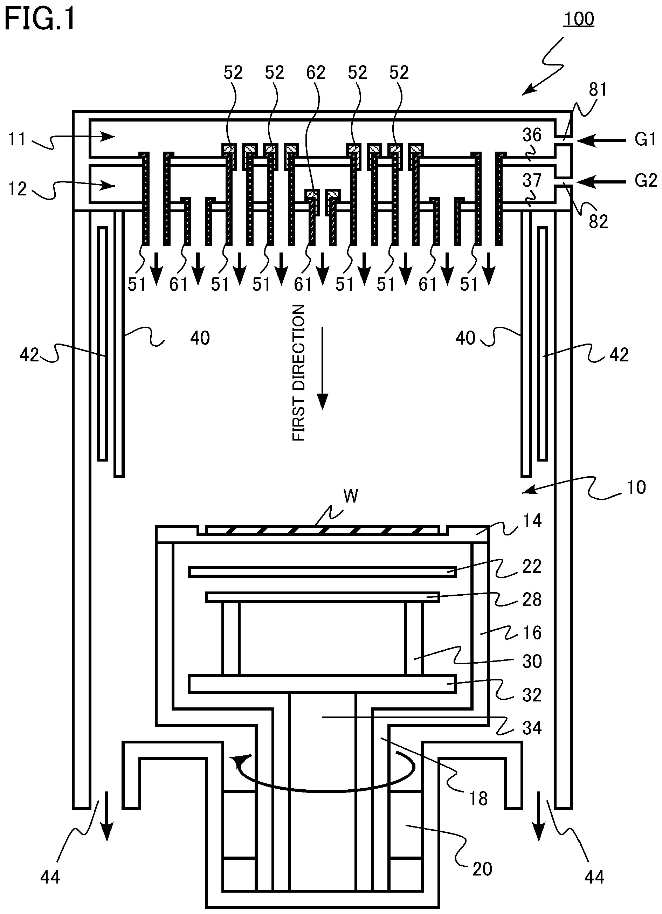

Fig. 1 is a schematic cross-sectional view of the vapor phase growth apparatus of the first embodiment. A vapor phase growth apparatus 100 of the first embodiment is, for example, a single wafer type epitaxial growth apparatus that epitaxially grows a single-crystal SiC film on a single-crystal SiC substrate.

The vapor phase growth apparatus 100 of the first embodiment includes a reactor 10, a first buffer chamber 11 (first gas chamber), and a second buffer chamber 12 (second gas chamber). The reactor 10 includes a susceptor 14 (holder), a rotating body 16, a rotating shaft 18, a rotation driving mechanism 20, a first heater 22, a reflector 28, a support column 30, a fixing table 32, a fixing shaft 34, a hood 40, a second heater 42, a gas discharge port 44, a first gas conduit 51, a first adjustment conduit 52, a second gas conduit 61, and a second adjustment conduit 62. The first buffer chamber 11 (gas chamber) includes a first partition plate 36 and a first gas supply port 81. The second buffer chamber 12 includes a second partition plate 37 and a second gas supply port 82.

The reactor 10 is formed of, for example, stainless steel. The reactor 10 has a cylindrical wall. An SiC film is formed on a wafer W in the reactor 10. The wafer W is an example of a substrate.

The susceptor 14 is provided in the reactor 10. The wafer W can be placed on the susceptor 14. An opening may be provided at the center of the susceptor 14. The susceptor 14 is an example of a holder.

The susceptor 14 is formed of, for example, a highly heat-resistant material such as SiC, carbon, or carbon coated with SiC or TaC.

The susceptor 14 is fixed to the upper part of the rotating body 16. The rotating body 16 is fixed to the rotating shaft 18. The susceptor 14 is indirectly fixed to the rotating shaft 18.

The rotating shaft 18 can be rotated by the rotation driving mechanism 20. By rotating the rotating shaft 18 using the rotation driving mechanism 20, it is possible to rotate the susceptor 14. By rotating the susceptor 14, it is possible to rotate the wafer W mounted on the susceptor 14.

With the rotation driving mechanism 20, for example, the wafer W can be rotated at a rotation speed of 300 rpm or more and 3000 rpm or less. The rotation driving mechanism 20 is formed by, for example, a motor and a bearing.

The first heater 22 is provided below the susceptor 14. The first heater 22 is provided in the rotating body 16. The first heater 22 heats the wafer W held by the susceptor 14 from below. The first heater 22 is, for example, a resistor heater. The first heater 22 has, for example, a disk shape with a comb-shaped pattern.

The reflector 28 is provided below the first heater 22. The first heater 22 is provided between the reflector 28 and the susceptor 14.

The reflector 28 reflects the heat radiated downward from the first heater 22 to improve the heating efficiency of the wafer W. In addition, the reflector 28 prevents the members below the reflector 28 from being heated. The reflector 28 has, for example, a disk shape. The reflector 28 is formed of, for example, a material having high heat resistance such as carbon coated with SiC.

The reflector 28 is fixed to the fixing table 32 by, for example, a plurality of support columns 30. The fixing table 32 is supported by, for example, the fixing shaft 34.

In order to attach and detach the susceptor 14 to and from the rotating body 16, a push up pin (not illustrated) is provided in the rotating body 16. The push up pin penetrates, for example, the reflector 28 and the first heater 22.

The second heater 42 is provided between the hood 40 and the inner wall of the reactor 10. The second heater 42 heats the wafer W held by the susceptor 14 from above. By heating the wafer W with the second heater 42 in addition to the first heater 22, it is possible to heat the wafer W to a temperature required for the growth of the SiC film, for example, a temperature of 1500°C or higher. The second heater 42 is, for example, a resistor heater.

The hood 40 has, for example, a cylindrical shape. The hood 40 has a function of preventing a first process gas G1 or a second process gas G2 from coming into contact with the second heater 42. The hood 40 is formed of, for example, a material having high heat resistance such as carbon coated with SiC.

The gas discharge port 44 is provided at the bottom of the reactor 10. The gas discharge port 44 discharges a surplus reaction product after the source gas reacts on the surface of the wafer W and a surplus process gas to the outside of the reactor 10. The gas discharge port 44 is connected to, for example, a vacuum pump (not illustrated).

In addition, a wafer inlet/outlet and a gate valve (not illustrated) are provided in the reactor 10. The wafer W can be loaded into the reactor 10 or unloaded to the outside of the reactor 10 by the wafer inlet/outlet and the gate valve.

The first buffer chamber 11 is provided above the reactor 10. The first gas supply port 81 for introducing the first process gas G1 is provided in the first buffer chamber 11. The first process gas G1 introduced from the first gas supply port 81 is filled in the first buffer chamber 11.

The first process gas G1 contains, for example, a silicon (Si) source gas. The first process gas G1 is, for example, a mixed gas of a silicon source gas, an assist gas for suppressing silicon clustering, and a carrier gas.

The silicon source gas is, for example, silane (SiH₄). The assist gas is, for example, hydrogen chloride (HCl). The carrier gas is, for example, hydrogen gas or argon gas.

The second buffer chamber 12 is provided above the reactor 10. The second buffer chamber 12 is provided between the reactor 10 and the first buffer chamber 11. The second gas supply port 82 for introducing the second process gas G2 is provided in the second buffer chamber 12. The second process gas G2 introduced from the second gas supply port 82 is filled in the second buffer chamber 12.

The second process gas G2 contains, for example, a carbon source gas. The second process gas G2 is, for example, a mixed gas of a carbon source gas, a dopant gas of n-type impurities, and a carrier gas.

The carbon source gas is, for example, propane (C₃H₈). The dopant gas of n-type impurities is, for example, nitrogen gas. The carrier gas is, for example, hydrogen gas or argon gas.

The plurality of first gas conduits 51 are provided between the first buffer chamber 11 and the reactor 10. The first gas conduit 51 extends from the first buffer chamber 11 in a first direction toward the reactor 10. The plurality of first gas conduits 51 supply the first process gas G1 from the first buffer chamber 11 to the reactor 10.

The first adjustment conduit 52 is inserted into at least one first gas conduit 51, among the plurality of first gas conduits 51, on the side of the first buffer chamber 11. Fig. 1 illustrates a case where the first adjustment conduit 52 is inserted only into the first gas conduit 51 in the central portion of the first buffer chamber 11. The first adjustment conduit 52 may be inserted into all of the plurality of first gas conduits 51.

The first adjustment conduit 52 has a function of adjusting the conductance of the gas flow path through the first gas conduit 51. By attaching the first adjustment conduit 52 to the first gas conduit 51, the conductance of the gas flow path through the first gas conduit 51 is reduced. The first adjustment conduit 52 adjusts the distribution ratio of the first process gas G1 flowing through the plurality of first gas conduits 51.

The plurality of second gas conduits 61 are provided between the second buffer chamber 12 and the reactor 10. The second gas conduit 61 extends from the second buffer chamber 12 in the first direction toward the reactor 10. The second gas conduit 61 supplies the second process gas G2 from the second buffer chamber 12 to the reactor 10.

The second adjustment conduit 62 is inserted into at least one second gas conduit 61, among the plurality of second gas conduits 61, on the side of the second buffer chamber 12. Fig. 1 illustrates a case where the second adjustment conduit 62 is inserted only into the second gas conduit 61 in the central portion of the second buffer chamber 12. The second adjustment conduit 62 may be inserted into all of the plurality of second gas conduits 61.

The second adjustment conduit 62 has a function of adjusting the conductance of the gas flow path through the second gas conduit 61. By attaching the second adjustment conduit 62 to the second gas conduit 61, the conductance of the gas flow path through the second gas conduit 61 is reduced. The second adjustment conduit 62 adjusts the distribution ratio of the second process gas G2 flowing through the plurality of second gas conduits 61.

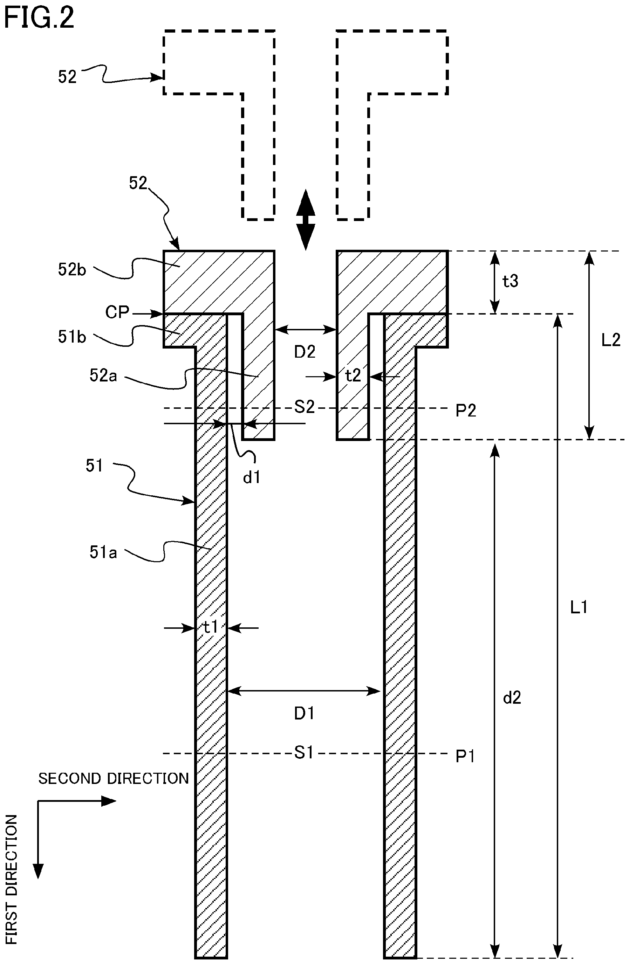

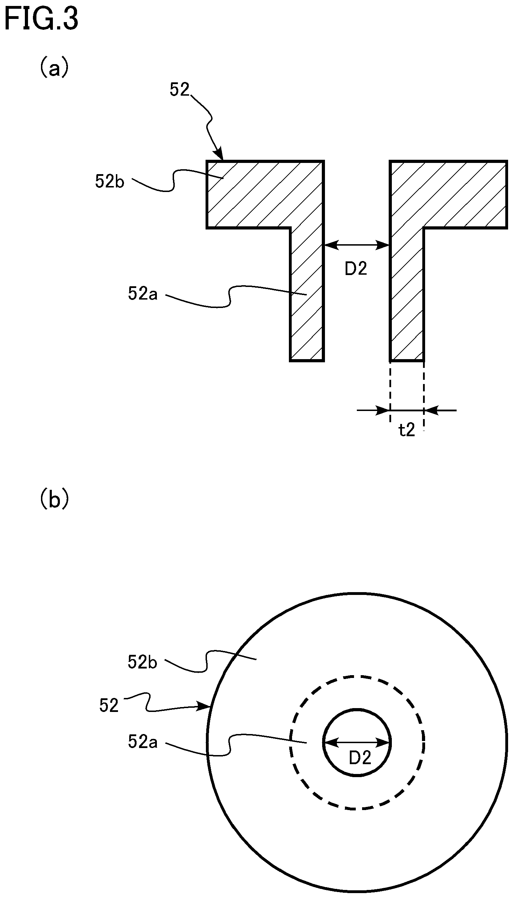

Fig. 2 is a schematic cross-sectional view of the first gas conduit and the first adjustment conduit of the first embodiment. Fig. 3 is a schematic diagram of the first adjustment conduit of the first embodiment. Fig. 3(a) is a cross-sectional view, and Fig. 3(b) is a top view.

The first gas conduit 51 extends in the first direction. The first gas conduit 51 has a first length L1 (predetermined length) in the first direction. The first gas conduit 51 has a cylindrical portion 51a and a flange 51b.

The cylindrical portion 51a has a first opening cross-sectional area S1 in a plane (P1 in Fig. 2) perpendicular to the first direction in which the process gas flows. A cross section of opening of the cylindrical portion 51a on the plane P1 is, for example, a circle having an inner diameter D1. The thickness t1 of the cylindrical portion 51a in a second direction is, for example, 0.5 mm or more and 5 mm or less.

The flange 51b is provided on the outer periphery of an end portion of the first gas conduit 51 on the side of the first buffer chamber 11. The flange 51b is an annular protrusion that protrudes outward from the cylindrical portion 51a. The outer diameter of the flange 51b is larger than the outer diameter of the cylindrical portion 51a.

The first gas conduit 51 is formed of, for example, a material having high heat resistance. The first gas conduit 51 is formed of, for example, carbon coated with SiC. By coating the carbon with SiC, the etching resistance to hydrogen gas is improved. The first gas conduit 51 may be, for example, metal or ceramics.

The first adjustment conduit 52 is inserted into the first gas conduit 51. The first adjustment conduit 52 can be removed from the first gas conduit 51. The first adjustment conduit 52 is fixed to the first gas conduit 51 by its own weight.

The first adjustment conduit 52 extends in the first direction. The first adjustment conduit 52 has a second length L2 in the first direction. The length L2 is shorter than the length L1. The first adjustment conduit 52 has a cylindrical portion 52a (part) and a flange 52b (protrusion).

The cylindrical portion 52a extends in the first direction. The cylindrical portion 52a has a second opening cross-sectional area S2 in a plane (P2 in Fig. 2) perpendicular to the first direction in which the process gas flows.

The second opening cross-sectional area S2 is smaller than the first opening cross-sectional area S1. The second opening cross-sectional area S2 is, for example, 10% or more and 80% or less of the first opening cross-sectional area S1.

The opening cross section of the cylindrical portion 52a on the plane P2 is, for example, a circle having an inner diameter D2. The inner diameter D2 is smaller than the inner diameter D1. The inner diameter D2 is, for example, 30% or more and 90% or less of the inner diameter D1.

The thickness t2 of the cylindrical portion 52a in the second direction is, for example, 0.5 mm or more and 2 mm or less.

The flange 52b is provided on the outer periphery of an end portion of the first adjustment conduit 52 on the side of the first buffer chamber 11. The flange 52b is an annular protrusion that protrudes outward from the cylindrical portion 52a. The outer diameter of the flange 52b is larger than the outer diameter of the cylindrical portion 52a.

The thickness t3 of the flange 52b in the first direction is larger than, for example, the thickness t2 of the cylindrical portion 52a in the second direction.

The material of the first adjustment conduit 52 is different from, for example, the material of the first gas conduit 51. The first adjustment conduit 52 is formed of, for example, a material having excellent workability. The first adjustment conduit 52 is formed of, for example, carbon. The first adjustment conduit 52 may be, for example, metal or ceramics.

The portion of the first adjustment conduit 52 inserted into the first gas conduit 51 and the first gas conduit 51 are spaced from each other at a predetermined distance in the radial direction of the first gas conduit 51. The portion of the first adjustment conduit 52 inserted into the first gas conduit 51 and the first gas conduit 51 are spaced from each other at a first distance d1 in the second direction perpendicular to the first direction. The distance between the cylindrical portion 52a of the first adjustment conduit 52 and the cylindrical portion 51a of the first gas conduit 51 in the second direction is the first distance d1. The first distance d1 is, for example, 0.5 mm or more and 5 mm or less.

A second distance d2 in the first direction between the end portion of the first adjustment conduit 52 on the side of the reactor 10 and the end portion of the first gas conduit 51 on the side of the reactor 10 is, for example, half or more of the length L1 of the first gas conduit 51 in the first direction.

The lower surface of the flange 52b of the first adjustment conduit 52 is in contact with the upper surface of the flange 51b of the first gas conduit 51. A contact surface (CP in Fig. 2) between the lower surface of the flange 52b and the upper surface of the flange 51b is an annular flat surface.

The contact surface CP is formed by pressing the lower surface of the flange 52b against the upper surface of the flange 51b by the weight of the first adjustment conduit 52. The contact surface CP suppresses the flow of the first process gas G1 between the lower surface of the flange 52b and the upper surface of the flange 51b. The first process gas G1 is sealed by the contact surface CP.

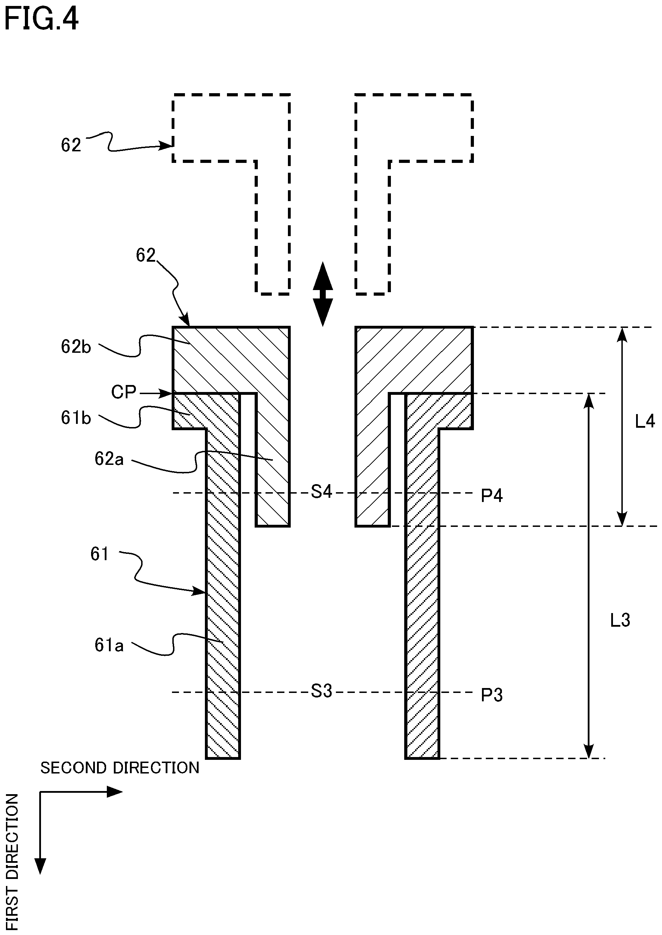

Fig. 4 is a schematic cross-sectional view of the second gas conduit and the second adjustment conduit of the first embodiment.

The second gas conduit 61 extends in the first direction. The second gas conduit 61 has a third length L3 in the first direction. The second gas conduit 61 has a cylindrical portion 61a and a flange 61b. The cylindrical portion 61a has a third opening cross-sectional area S3 in a plane (P3 in Fig. 4) perpendicular to the first direction in which the process gas flows.

The second adjustment conduit 62 is inserted into the second gas conduit 61. The second adjustment conduit 62 can be removed from the second gas conduit 61. The second adjustment conduit 62 is fixed to the second gas conduit 61 by its own weight.

The second adjustment conduit 62 extends in the first direction. The second adjustment conduit 62 has a fourth length L4 in the first direction. The length L4 is shorter than the length L3. The second adjustment conduit 62 has a cylindrical portion 62a and a flange 62b. The cylindrical portion 62a has a fourth opening cross-sectional area S4 in a plane (P4 in Fig. 4) perpendicular to the first direction in which the process gas flows.

The second gas conduit 61 may have different dimensions and the like from the first gas conduit 51, but has the same configuration. The second adjustment conduit 62 may have different dimensions and the like from the first adjustment conduit 52, but has the same configuration.

Next, the function and effect of the vapor phase growth apparatus of the first embodiment will be described.

In a vapor phase growth apparatus using an epitaxial growth technique, a substrate is placed on a holder in a reactor held at normal pressure or reduced pressure. Then, while heating the substrate, a process gas containing the raw material of a film is supplied to the reactor through a buffer chamber at the upper part of the reactor. A thermal reaction of the process gas occurs on the surface of the substrate, and an epitaxial single crystal film is formed on the surface of the substrate.

For example, it may not be possible to obtain the reproducibility of the characteristics of a film formed under the same process conditions between different vapor phase growth apparatuses having the same specifications. The characteristics of the film are, for example, the film thickness, the uniformity of the film thickness, the impurity concentration in the film, and the uniformity of the impurity concentration in the film.

The reason why the reproducibility cannot be obtained is considered to be, for example, a dimensional variation within the processing tolerance of the parts forming each vapor phase growth apparatus. For example, it is conceivable that the reproducibility of the pressure distribution in the gas chamber cannot be obtained due to the dimensional variation of the flow path for supplying the process gas to the buffer chamber, and accordingly, the reproducibility of the film characteristics cannot be obtained.

For example, according to a change in the pressure distribution in the buffer chamber, the distribution ratio of the gas flow rate among the plurality of gas conduits for supplying the process gas to the reactor changes. For this reason, the flow rate distribution of the process gas supplied to the reactor changes, so that the characteristics of the film cannot be reproduced.

In the vapor phase growth apparatus 100 of the first embodiment, the first adjustment conduit 52 that is removable is attached to the first gas conduit 51. The first adjustment conduit 52 is attached to at least one of the plurality of first gas conduits 51.

The second opening cross-sectional area S2 of the first adjustment conduit 52 is smaller than the first opening cross-sectional area S1 of the first gas conduit 51. For this reason, by attaching the first adjustment conduit 52 to the first gas conduit 51, the conductance of the gas flow path through the first gas conduit 51 is reduced. Therefore, by attaching the first adjustment conduit 52, it is possible to suppress the flow rate of the first process gas G1 flowing through the first gas conduit 51.

For example, the first adjustment conduit 52 is attached to only some first gas conduits 51 among the plurality of first gas conduits 51. This makes it possible to change the distribution ratio of the first process gas G1 among the plurality of first gas conduits 51. Therefore, it is possible to change the flow rate distribution of the first process gas G1 supplied to the reactor 10.

In addition, for example, the second opening cross-sectional areas S2 of the plurality of first adjustment conduits 52 attached to the plurality of first gas conduits 51 are made different among the different first adjustment conduits 52. This makes it possible to change the distribution ratio of the first process gas G1 among the plurality of first gas conduits 51. Therefore, it is possible to change the flow rate distribution of the first process gas G1 supplied to the reactor 10.

By appropriately selecting the position of the first gas conduit 51 to which the first adjustment conduit 52 is attached or the size of the second opening cross-sectional area S2 of the first adjustment conduit 52, it is possible to realize a desired flow rate distribution of the first process gas G1 in the reactor 10.

Similar to the case of using the first adjustment conduit 52, by appropriately selecting the position of the second gas conduit 61 to which the second adjustment conduit 62 is attached or the size of the fourth opening cross-sectional area S4 of the second adjustment conduit 62, it is possible to realize a desired flow rate distribution of the second process gas G2 in the reactor 10.

According to the vapor phase growth apparatus 100 of the first embodiment, the desired flow rate distribution of the first process gas G1 or the desired flow rate distribution of the second process gas G2 in the reactor 10 can be realized by using the first adjustment conduit 52 or the second adjustment conduit 62. Therefore, it is possible to improve the reproducibility of the film characteristics between different vapor phase growth apparatuses having the same specifications.

It is preferable that the portion of the first adjustment conduit 52 inserted into the first gas conduit 51 and the first gas conduit 51 are spaced from each other in the second direction perpendicular to the first direction in which the first process gas G1 flows. In other words, it is preferable that the cylindrical portion 52a of the first adjustment conduit 52 and the cylindrical portion 51a of the first gas conduit 51 are spaced from each other in the second direction.

Since the cylindrical portion 52a of the first adjustment conduit 52 and the cylindrical portion 51a of the first gas conduit 51 are spaced from each other in the second direction, for example, interference due to the difference in the degree of thermal expansion between the first adjustment conduit 52 and the first gas conduit 51 is reduced, so that it is possible to suppress a situation in which the first adjustment conduit 52 or the first gas conduit 51 is damaged.

From the viewpoint of suppressing damage to the first adjustment conduit 52 or the first gas conduit 51, the first distance d1 (predetermined distance) between the cylindrical portion 52a of the first adjustment conduit 52 and the cylindrical portion 51a of the first gas conduit 51 in the second direction (radial direction) is preferably 0.5 mm or more, and more preferably 1 mm or more.

In addition, from the viewpoint of securing the flow rate of the first process gas G1 flowing through the first adjustment conduit 52, the first distance d1 is preferably 5 mm or less.

The second distance d2 in the first direction between the end portion of the first adjustment conduit 52 on the side of the reactor 10 and the end portion of the first gas conduit 51 on the side of the reactor 10 is preferably half or more of the length L1 of the first gas conduit 51 in the first direction, and more preferably two-thirds or more.

By increasing the second distance d2, the thermal expansion of the first adjustment conduit 52 can be suppressed. Therefore, for example, it is possible to suppress a situation in which the first adjustment conduit 52 is deformed by thermal expansion and accordingly the sealing of the first process gas G1 is adversely affected by the contact surface CP. In addition, by increasing the second distance d2, a material having low heat resistance can be used for the first adjustment conduit 52.

The second opening cross-sectional area S2 of the first adjustment conduit 52 is preferably 10% or more and 80% or less of the first opening cross-sectional area S1 of the first gas conduit 51, and preferably 20% or more and 70% or less. By making the second opening cross-sectional area S2 of the first adjustment conduit 52 smaller than the above upper limit value, the conductance of the first gas conduit 51 can be sufficiently reduced. In addition, by making the second opening cross-sectional area S2 of the first adjustment conduit 52 larger than the above lower limit value, it is suppressed that the conductance becomes too small.

The inner diameter D2 of the first adjustment conduit 52 is preferably 30% or more and 90% or less of the inner diameter D1 of the first gas conduit 51, and more preferably 40% or more and 80% or less. By making the inner diameter D2 of the first adjustment conduit 52 smaller than the above upper limit value, the conductance of the first gas conduit 51 can be sufficiently reduced. In addition, by making the inner diameter D2 of the first adjustment conduit 52 larger than the above lower limit value, it is suppressed that the conductance becomes too small.

The thickness t2 of the cylindrical portion 52a of the first adjustment conduit 52 in the second direction is preferably 0.5 mm or more and 2 mm or less, and more preferably 0.7 mm or more and 1.5 mm or less. In addition, by making the thickness t2 of the cylindrical portion 52a of the first adjustment conduit 52 in the second direction larger than the above lower limit value, sufficient strength can be secured. In addition, by making the thickness t2 of the cylindrical portion 52a of the first adjustment conduit 52 in the second direction smaller than the above upper limit value, it is suppressed that the conductance of the gas flow path through the first gas conduit 51 becomes too small.

The thickness t3 of the flange 52b of the first adjustment conduit 52 in a direction perpendicular to the radial direction of the first adjustment conduit 52 is larger than the thickness t2 of the portion of the first adjustment conduit 52, which is inserted into the first gas conduit 51, in the radial direction of the first adjustment conduit 52. The thickness t3 of the flange 52b of the first adjustment conduit 52 in the first direction is preferably larger than the thickness t2 of the cylindrical portion 52a of the first adjustment conduit 52 in the second direction. By increasing the thickness t3 of the flange 52b, the weight of the first adjustment conduit 52 increases. Therefore, for example, when the first buffer chamber 11 has a negative pressure with respect to the reactor 10, it is possible to prevent the first adjustment conduit 52 from coming out of the first gas conduit 51.

It is preferable that the material of the first gas conduit 51 and the material of the first adjustment conduit 52 are different. By changing the material of the first gas conduit 51 and the material of the first adjustment conduit 52, the optimal material for each function can be used.

For example, for the first gas conduit 51 suffering a high temperature because at least its end portion is exposed in the reactor 10, it is preferable to use a material having high heat resistance or etching resistance. For example, for the first gas conduit 51, carbon coated with SiC having high heat resistance and etching resistance is used.

For example, for the first adjustment conduit 52 whose temperature does not rise relatively, it is preferable to use a material having excellent workability or economical efficiency rather than heat resistance or etching resistance. For example, for the first adjustment conduit 52, carbon having no coat layer on the surface, which is excellent in terms of workability and economical efficiency, is used.

As described above, according to the vapor phase growth apparatus of the first embodiment, it is possible to adjust the flow rate distribution of the process gas supplied to the reactor. Therefore, according to the vapor phase growth apparatus of the first embodiment, it is possible to improve the reproducibility of the film characteristics.

### (Second Embodiment)

A vapor phase growth apparatus of a second embodiment is different from the vapor phase growth apparatus of the first embodiment in that the shapes of the gas conduit and the adjustment conduit are different. Hereinafter, the description of a part of the content overlapping the first embodiment will be omitted.

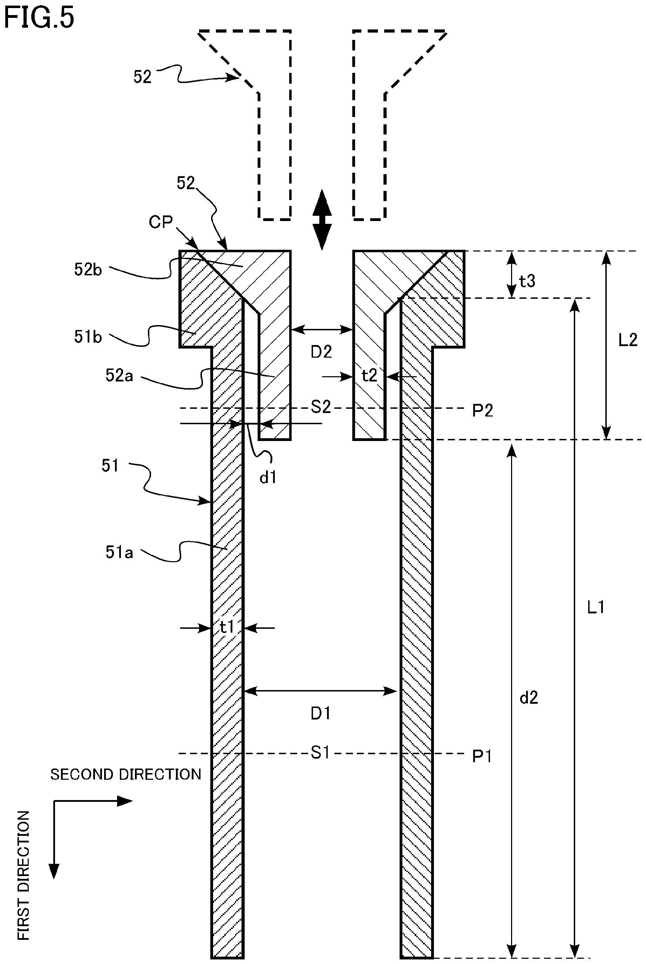

Fig. 5 is a schematic cross-sectional view of a first gas conduit and a first adjustment conduit of the second embodiment.

A flange 51b of a first gas conduit 51 is provided on the outer periphery of an end portion of the first gas conduit 51 on the side of a first buffer chamber 11. The flange 51b is an annular protrusion that protrudes outward from a cylindrical portion 51a.

At least a part of the inner peripheral surface of the first gas conduit 51 has a tapered shape. The inner peripheral surface of the flange 51b has a tapered shape. The inner peripheral surface of the flange 51b is inclined with respect to the first direction and the second direction. The distance from the tapered end portion of the first gas conduit 51 to the end portion on the reactor side is defined as a first length L1 (predetermined length).

A flange 52b of a first adjustment conduit 52 is provided on the outer periphery of an end portion of the first adjustment conduit 52 on the side of the first buffer chamber 11. The flange 52b is an annular protrusion that protrudes outward from a cylindrical portion 52a.

The outer peripheral surface of the flange 52b has a tapered shape. The outer peripheral surface of the flange 52b is inclined with respect to the first direction and the second direction.

The outer peripheral surface of the flange 52b of the first adjustment conduit 52 is in contact with the inner peripheral surface of the flange 51b of the first gas conduit 51. A contact surface (CP in Fig. 5) between the outer peripheral surface of the flange 52b and the inner peripheral surface of the flange 51b is annular, and has a shape corresponding to the outer surface of the truncated cone.

The contact surface CP is formed by pressing the outer peripheral surface of the flange 52b against the inner peripheral surface of the flange 51b by the weight of the first adjustment conduit 52. The contact surface CP suppresses the flow of the first process gas G1 between the lower surface of the flange 52b and the upper surface of the flange 51b. The first process gas G1 is sealed by the contact surface CP.

As described above, according to the vapor phase growth apparatus of the second embodiment, it is possible to adjust the flow rate distribution of the process gas supplied to the reactor as in the first embodiment. Therefore, according to the vapor phase growth apparatus of the second embodiment, it is possible to improve the reproducibility of the film characteristics.

### (Third Embodiment)

A vapor phase growth apparatus of a third embodiment is different from the vapor phase growth apparatus of the first embodiment in that there is one gas chamber. Hereinafter, the description of a part of the content overlapping the first embodiment will be omitted.

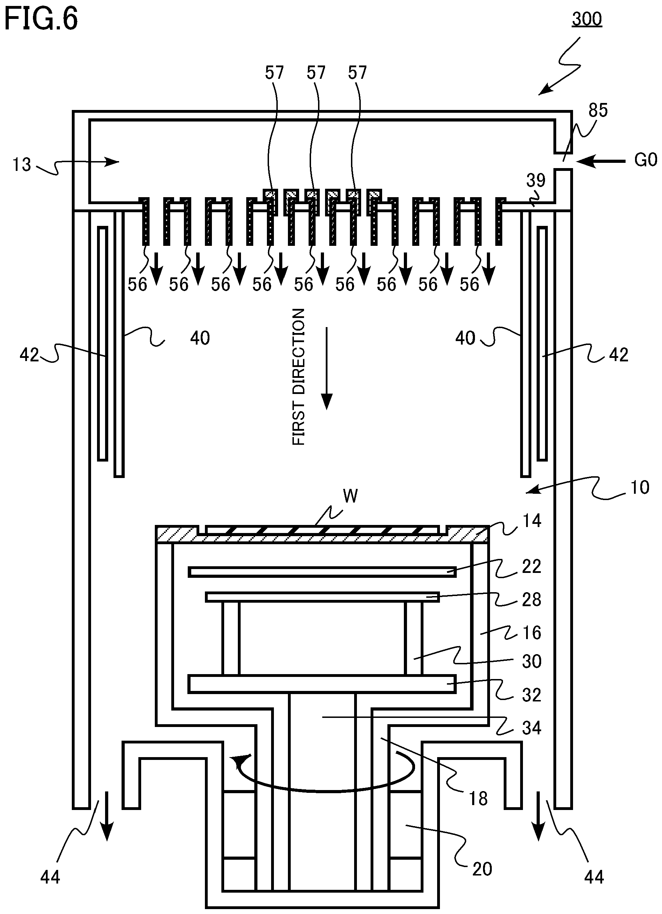

Fig. 6 is a schematic cross-sectional view of the vapor phase growth apparatus of the third embodiment. A vapor phase growth apparatus 300 of the third embodiment is, for example, a single wafer type epitaxial growth apparatus that epitaxially grows a single-crystal SiC film on a single-crystal SiC substrate.

The vapor phase growth apparatus 300 of the third embodiment includes a reactor 10 and a buffer chamber 13 (gas chamber). The reactor 10 includes a susceptor 14 (holder), a rotating body 16, a rotating shaft 18, a rotation driving mechanism 20, a first heater 22, a reflector 28, a support column 30, a fixing table 32, a fixing shaft 34, a hood 40, a second heater 42, a gas discharge port 44, a gas conduit 56, and an adjustment conduit 57. The buffer chamber 13 includes a partition plate 39 and a gas supply port 85.

The buffer chamber 13 is provided above the reactor 10. The gas supply port 85 for introducing a process gas G0 is provided in the buffer chamber 13. The process gas G0 introduced from the gas supply port 85 is filled in the buffer chamber 13.

The process gas G0 is, for example, a mixed gas containing a silicon (Si) source gas, a carbon (C) source gas, a dopant gas of n-type impurities, an assist gas for suppressing silicon clustering, and a carrier gas. The silicon source gas is, for example, silane (SiH₄). The carbon source gas is, for example, propane (C₃H₈). The dopant gas of n-type impurities is, for example, nitrogen gas. The assist gas is, for example, hydrogen chloride (HCl). The carrier gas is, for example, argon gas or hydrogen gas.

A plurality of gas conduits 56 are provided between the buffer chamber 13 and the reactor 10. The gas conduit 56 extends from the buffer chamber 13 in the first direction toward the reactor 10. The plurality of gas conduits 56 supply the process gas G0 from the buffer chamber 13 to the reactor 10. The gas conduit 56 has, for example, the same configuration as the first gas conduit 51 of the first embodiment.

The adjustment conduit 57 is inserted into at least one gas conduit 56, among the plurality of gas conduits 56, on the side of the buffer chamber 13. Fig. 3 illustrates a case where the adjustment conduit 57 is inserted only into the gas conduit 56 in the central portion of the buffer chamber 13. The adjustment conduit 57 may be inserted into all of the plurality of gas conduits 56. The adjustment conduit 57 adjusts the distribution ratio of the process gas G0 flowing through the plurality of gas conduits 56. The adjustment conduit 57 has, for example, the same configuration as the first adjustment conduit 52 of the first embodiment.

As described above, according to the vapor phase growth apparatus of the third embodiment, it is possible to adjust the flow rate distribution of the process gas supplied to the reactor as in the first embodiment. Therefore, according to the vapor phase growth apparatus of the third embodiment, it is possible to improve the reproducibility of the film characteristics.

The embodiments of the invention have been described above with reference to specific examples. The above-described embodiments are merely given as examples, and do not limit the invention. In addition, the components of the respective embodiments may be appropriately combined.

In the embodiments, the case of forming a single-crystal SiC film has been described as an example. However, the invention can also be applied to the formation of a polycrystalline or amorphous SiC film. In addition, the invention can also be applied to the formation of a film other than the SiC film.

In addition, in the embodiments, the wafer of single-crystal SiC has been described as an example of the substrate. However, the substrate is not limited to the wafer of single-crystal SiC.

In addition, in the embodiments, nitrogen has been described as an example of the n-type impurity. However, for example, phosphorus (P) can also be applied as the n-type impurity. In addition, p-type impurities can also be applied as impurities.

In addition, in the embodiments, the case where the conduit has a cylindrical shape has been described as an example. However, the shape of the conduit is not limited to the cylindrical shape and may be any other shape. In addition, in the embodiments, the case where the opening cross section of the conduit is circular has been described as an example. However, the opening cross section of the conduit is not limited to the circular shape, and may have other shapes such as an ellipse, a square, and a rectangle.

In addition, for example, in the first embodiment, a sealing member for sealing the process gas can also be provided between the lower surface of the flange 52b of the first adjustment conduit 52 and the upper surface of the flange 51b of the first gas conduit 51. The material of the sealing member is, for example, a carbon sheet.

In addition, for example, in the first embodiment, it is also possible to provide a screw hole in the flange 52b of the first adjustment conduit 52 and fix the first adjustment conduit 52 and the first partition plate 36 with a fixing screw.

In the embodiments, the case of improving the reproducibility of the characteristics of the film formed under the same process conditions between different vapor phase growth apparatuses having the same specifications has been described as an example. However, for example, when the characteristics of the film change with time in the same vapor phase growth apparatus, the invention can also be used to improve the reproducibility of the characteristics of the film. In addition, for example, when it is desired to improve the uniformity of the film characteristics with the same vapor phase growth apparatus, the invention can also be used.

In the embodiments, the description of parts that are not directly required for the description of the invention, such as the apparatus configuration or the manufacturing method, is omitted. However, the required apparatus configuration, manufacturing method, and the like can be appropriately selected and used. In addition, all vapor phase growth apparatuses that include the elements of the invention and that can be appropriately redesigned by those skilled in the art are included in the scope of the invention. The scope of the invention is defined by the scope of claims and the scope of their equivalents.

### EXPLANATIONS OF LETTERS OR NUMERALS

- 10: REACTOR
- 11: FIRST BUFFER CHAMBER (FIRST GAS CHAMBER)
- 12: SECOND BUFFER CHAMBER (SECOND GAS CHAMBER)
- 13: BUFFER CHAMBER (GAS CHAMBER)
- 14: SUSCEPTOR
- 16: ROTATING BODY
- 18: ROTATING SHAFT
- 20: ROTATION DRIVING MECHANISM
- 22: FIRST HEATER
- 28: REFLECTOR
- 30: SUPPORT COLUMN
- 32: FIXING TABLE
- 34: FIXING SHAFT
- 36: FIRST PARTITION PLATE
- 37: SECOND PARTITION PLATE
- 39: PARTITION PLATE
- 40: HOOD
- 42: SECOND HEATER
- 44: GAS DISCHARGE PORT
- 51: FIRST GAS CONDUIT
- 51a: CYLINDRICAL PORTION
- 51b: FLANGE
- 52: FIRST ADJUSTMENT CONDUIT
- 52a: CYLINDRICAL PORTION (PART)
- 52b: FLANGE (PROTRUSION)
- 56: GAS CONDUIT
- 57: ADJUSTMENT CONDUIT
- 61: SECOND GAS CONDUIT
- 62: SECOND ADJUSTMENT CONDUIT
- 81: FIRST GAS SUPPLY PORT
- 82: SECOND GAS SUPPLY PORT
- 85: GAS SUPPLY PORT
- 100: VAPOR PHASE GROWTH APPARATUS
- 300: VAPOR PHASE GROWTH APPARATUS
- CP: CONTACT SURFACE
- G0: PROCESS GAS
- G1: FIRST PROCESS GAS (PROCESS GAS)
- G2: SECOND PROCESS GAS
- W: WAFER (SUBSTRATE)
- L1: FIRST LENGTH (PREDETERMINED LENGTH)
- L2: SECOND LENGTH
- L3: THIRD LENGTH
- L4: FOURTH LENGTH
- S1: FIRST OPENING CROSS-SECTIONAL AREA
- S2: SECOND OPENING CROSS-SECTIONAL AREA
- S3: THIRD OPENING CROSS-SECTIONAL AREA
- S4: FOURTH OPENING CROSS-SECTIONAL AREA
- d1: FIRST DISTANCE (PREDETERMINED DISTANCE)
- d2: SECOND DISTANCE

## Claims

1. A vapor phase growth apparatus, comprising:
a reactor;
a first gas chamber provided above the reactor, a first process gas being introduced into the first gas chamber;
a plurality of first gas conduits supplying the first process gas from the first gas chamber to the reactor, each of the first gas conduits having a predetermined length; and
a first adjustment conduit inserted to an upper side of one of the plurality of first gas conduits,
wherein the first adjustment conduit has an annular protrusion provided on an outer periphery of an upper end portion and the first adjustment conduit is removable from the first gas conduit.

2. The vapor phase growth apparatus according to claim 1,
wherein a portion of the first adjustment conduit inserted into the first gas conduit and the first gas conduit are spaced from each other at a predetermined distance in a radial direction of the first gas conduit.

3. The vapor phase growth apparatus according to claim 2,
wherein the predetermined distance is 0.5 mm or more and 5 mm or less.

4. The vapor phase growth apparatus according to claim 1,
wherein a distance between a lower end of the first adjustment conduit and a lower end of the first gas conduit into which the first adjustment conduit is inserted is half or more of the predetermined length.

5. The vapor phase growth apparatus according to claim 1,
wherein a material of the first gas conduit and a material of the first adjustment conduit are different.

6. The vapor phase growth apparatus according to claim 1,
wherein an inner diameter of the first adjustment conduit is 30% or more and 90% or less of an inner diameter of the first gas conduit.

7. The vapor phase growth apparatus according to claim 1,
wherein a thickness of the annular protrusion in a direction perpendicular to a radial direction of the first adjustment conduit is larger than a thickness of a portion of the first adjustment conduit inserted into the first gas conduit in the radial direction.

8. The vapor phase growth apparatus according to claim 1,
wherein an outer peripheral surface of the annular protrusion has a tapered shape.

9. The vapor phase growth apparatus according to claim 8,
wherein at least a part of the first gas conduit has a tapered shape.

10. The vapor phase growth apparatus according to claim 1, further comprising:
a second gas chamber provided between the reactor and the first gas chamber, a second process gas different from the first process gas being introduced into the second gas chamber;
a plurality of second gas conduits for supplying the second process gas from the second gas chamber to the reactor, each of the second gas conduits having a predetermined length; and
a second adjustment conduit inserted to an upper side of one of the plurality of second gas conduits,
wherein the second adjustment conduit has an annular protrusion provided on an outer periphery of an upper end portion and the second adjustment conduit is removable from the second gas conduit.

## Amended claims

### Amended claims under Art. 19.1 PCT

1. (Amended) A vapor phase growth apparatus, comprising:
a reactor;
a first gas chamber provided above the reactor, a first process gas being introduced into the first gas chamber;
a plurality of first gas conduits supplying the first process gas from the first gas chamber to the reactor, each of the first gas conduits having a predetermined length; and
a first adjustment conduit inserted to an upper side of one of the plurality of first gas conduits,
wherein the first adjustment conduit has an annular protrusion provided on an outer periphery of an upper end portion and the first adjustment conduit is removable from the first gas conduit, and
a portion of the first adjustment conduit inserted into the first gas conduit and the first gas conduit are spaced from each other at a predetermined distance in a radial direction of the first gas conduit.

2. (Deleted)

3. (Amended) The vapor phase growth apparatus according to claim 1,
wherein the predetermined distance is 0.5 mm or more and 5 mm or less.

4. The vapor phase growth apparatus according to claim 1,
wherein a distance between a lower end of the first adjustment conduit and a lower end of the first gas conduit into which the first adjustment conduit is inserted is half or more of the predetermined length.

5. The vapor phase growth apparatus according to claim 1,
wherein a material of the first gas conduit and a material of the first adjustment conduit are different.

6. The vapor phase growth apparatus according to claim 1,
wherein an inner diameter of the first adjustment conduit is 30% or more and 90% or less of an inner diameter of the first gas conduit.

7. The vapor phase growth apparatus according to claim 1,
wherein a thickness of the annular protrusion in a direction perpendicular to a radial direction of the first adjustment conduit is larger than a thickness of a portion of the first adjustment conduit inserted into the first gas conduit in the radial direction.

8. The vapor phase growth apparatus according to claim 1,
wherein an outer peripheral surface of the annular protrusion has a tapered shape.

9. The vapor phase growth apparatus according to claim 8,
wherein at least a part of the first gas conduit has a tapered shape.

10. (Amended) The vapor phase growth apparatus according to claim 1, further comprising:
a second gas chamber provided between the reactor and the first gas chamber, a second process gas different from the first process gas being introduced into the second gas chamber;
a plurality of second gas conduits for supplying the second process gas from the second gas chamber to the reactor, each of the second gas conduits having a predetermined length; and
a second adjustment conduit inserted to an upper side of one of the plurality of second gas conduits,
wherein the second adjustment conduit has an annular protrusion provided on an outer periphery of an upper end portion and the second adjustment conduit is removable from the second gas conduit, and
a portion of the second adjustment conduit inserted into the second gas conduit and the second gas conduit are spaced from each other at a predetermined distance in a radial direction of the second gas conduit.
